# EUROPEAN PATENT SPECIFICATION

(11) **EP 3 640 998 B1**
(45) Date of publication and mention of the grant of the patent: **22.02.2023**
(21) Application number: 19203650.7
(22) Date of filing: 16.10.2019
(51) Int. Cl.: H01L 35/30, E04D 13/00

(54) **ROOF UNIT, ROOFTOP SYSTEM AND METHOD FOR MANUFACTURING**
DACHMODUL, DACHSYSTEM UND VERFAHREN ZUR HERSTELLUNG
UNITÉ DE TOITURE, SYSTÈME DE TOIT ET PROCÉDÉ DE FABRICATION

(30) Priority: 17.10.2018 EP 18201003
(43) Date of publication of application: 22.04.2020
(73) Proprietor: SIKA TECHNOLOGY AG, 6340 Baar (CH)
(72) Inventor: Carl, Wilfried, 8820 Wädenswil (CH); Heidtman, Patricia, 6010 Kriens (CH)
(74) Representative: Sika Patent Attorneys

(56) References cited:
- EP-A1- 1 818 992
- EP-A1- 2 239 787
- EP-A1- 3 539 767
- EP-A2- 2 356 703
- EP-A2- 2 876 697
- DE-A1- 19 946 806
- MANEEWAN S ET AL: "Experimental investigation on generated power of thermoelectric roof solar collector", THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17 August 2003 (2003-08-17), pages 574-577, XP010697379, ISBN: 978-0-7803-8301-2

## Description

The invention refers to a roof unit, in particular for buildings. Further, the invention refers to a rooftop system and a method for manufacturing the same.

Although thermoelectric power generation by thermoelectric generators or so called "Seebeck elements" has been known for a long time, it has been limited to high temperature applications, such as e.g. hot pipes in industrial applications, recently. Thereby, suitable heat sinks for the "cold side" of the Seebeck elements had to be provided additionally.

For example, patent application DE 10 2009 051 302 A1 discloses the coupling of a solar thermal system with a thermoelectrical generator. However, this arrangement necessitates a large space and further infrastructure such as fluid tanks and fluid pipes. Furthermore, EP 2 876 697 A2 discloses a thermoelectric generator arranged in a housing, which may be installed in a building.

The object of the invention is to provide a roof unit which is capable of generating electrical energy due to environmental conditions, maintenance-free, easy to handle during installation, provides a space-saving arrangement and can be used even under harsh environmental conditions as well. Further it is an object of the invention to provide a rooftop system and a method for manufacturing of such a roof unit and/or a rooftop system.

Referring to the roof unit, the object is solved by independent claim 1, with regard to the rooftop system by claim 15 and with regard to the method for manufacturing by claim 17. Preferable embodiments are disclosed by the dependent claims respectively.

According to the present invention, the roof unit, in particular for buildings, comprises a cover membrane, at least one thermoelectric generator for providing electrical energy with a first side and a second side, an insulation member with an outer and an inner side, and at least one thermal bridge member. The cover membrane is attached to the first side of the thermoelectric generator, whereby the second side of the thermoelectric generator and the outer side of the insulation member are arranged next to each other and are separated from each other by the thermal bridge member. The thermal bridge member partially extends between the second side of the thermoelectric generator and the outer side of the insulation member. Further, the thermal bridge member reaches to the inner side of the insulation member along a thickness of the insulation member such that a thermal bridge between an area along the inner side of the insulation member and the second side of the thermoelectric generator is provided, wherein the cover membrane is a roofing membrane.

The present invention is based on the approach to generate electrical energy from temperature differences between inner and outer sides of a rooftop of e.g. a building by using at least one thermoelectric generator. Thus, a specific feature of this invention is the use of one or several thermoelectric generator elements in combination with a thermal bridge to utilize the temperature gradient between the covering membrane of the roof unit, exposed to ambient temperature and radiation, and the building interior.

Thus, the thermal bridge is provided in order to use such a suitable temperature difference despite the insulation members along a rooftop, whereby the thermal bridge can transfer a temperature, in particular a thermal energy, from an inner side of a building preferably around an insulation member to the thermoelectric generator, thereby forming a thermal bypass.

In the context of the present invention a transfer of temperature by the thermal bridge member has to be considered as a transport of thermal energy, in particular from an area along the inner side of the insulation member to the second side of the thermoelectric generator, in order to allow a maximum temperature difference to be present between the first and second side of the thermoelectric generator for the purpose of generating electrical energy.

Further, the thermal bridge member can be considered as a heat sink or as a heat source at the second side of the thermoelectric generator, depending on the ambient temperature, the inside temperature of e.g. a building and the temperature difference resulting therefrom.

Consequently, electrical energy can be generated as long as a temperature difference exists between the inner side of the building and the environment at its outer side and consequently independent from the time of the year. Further, by using thermoelectric generators in combination with thermal bridge members, the roof unit can be provided as a space-saving arrangement.

Preferably, a first side of the thermoelectric generator is directed to the cover membrane of the roof unit and thus to an outer side of the roof of e.g. a building. In addition, the cover membrane is attached to the first side of the thermoelectric generator. Thus, a thin and space-saving arrangement of the roof unit is achieved.

The second side of the thermoelectric generator is preferably directed to the insulation member and thus to an inner side of the building. Further, the thermoelectric generator and the insulation member are arranged side by side and are only separated from each other by the thermal bridge member.

The thermal bridge member partially extends between the second side of the thermoelectric generator and the outer side of the insulation member. In particular, only a part of the thermal bridge member is arranged along the second side of the thermoelectric generator and thus between the thermoelectric generator and the outer side of the insulation member. Moreover, the thermal bridge member further reaches to the inner side of the insulation member along a thickness of the insulation member to provide a thermal bridge between an area along the inner side of the insulation member and the second side of the thermoelectric generator.

In particular, the thermal bridge member extends from the inner side of the insulation member to the outer side of the insulation member and the second side of the thermoelectric generator to allow a temperature to be transferred to the thermoelectric generator. In this regard, the thermal bridge member can be considered as a bypass, in particular a thermal bypass.

The area along the inner side of the insulation member can be understood as e.g. a volume of the building or a surface of the insulation member, which preferably has at least approximately the inside temperature of the building. Thus, the temperature inside of e.g. a building can be transferred to the thermoelectric generator, in particular to the second side of the thermoelectric generator, and through the insulation of the building, in particular around the insulation member of the roof unit, by the thermal bridge member.

In particular, the thermal bridge member does not have a substantial impact on the insulation properties of e.g. a building's insulation. Preferably, the insulation member of a roof unit does not have to be artificially weakened with respect to its insulation properties in order to allow the thermal bridge member to pass through the insulation of a building's rooftop, which is made of multiple insulation members being arranged next to each other. Rather, the preferably thin thermal bridge member is able to pass through spatial separations between the individual insulations members of such a rooftop's insulation.

Consequently, an easy assembling of the roof unit as well as a suitable insulation, without substantial impact by the thermal bridge member, is provided.

According to an alternative embodiment of the present invention, the thermal bridge member can directly pass through an insulation member of the respective roof unit, in particular through an artificial cut, a groove, a recess or the like in the insulation member. Thus, the thermal bridge member is arranged along a more direct pathway in order to provide a thermal bridge between an area along the inner side of the insulation member and the second side of the thermoelectric generator.

In a preferred embodiment, the thermal bridge member extends around at least a part of an exterior surface, in particular along the inner and outer surface, of the insulation member, preferably around the complete exterior surface of the insulation member.

According to the invention, the exterior surface of the insulation member includes all side surfaces of the insulation member. Thus, the exterior surface includes the outer and inner surface as well as lateral surfaces, in particular substantially vertical side surfaces, which extend along the thickness direction of the insulation member.

The thermal bridge member extends along the inner and outer surface as well as in the direction of thickness of the insulation member, in particular along at least one side surface of the insulation member. Thus, an internal temperature of a building can be transferred around the insulation member to the second side of the thermoelectric generator by the thermal bridge member.

In a further embodiment of the invention, the first side of the at least one thermoelectric generator is completely covered by the cover membrane. In particular, the thermoelectric generator, the insulation member and the thermal bridge member are protected from environmental conditions such as storms with hail, formation of ice during cold periods, sand dust and the like by the cover membrane.

The cover membrane preferably extends above the thermoelectric generator such that the roof unit comprises a complete protective top layer. In consequence, the thermoelectric generator is not only in direct contact with the cover membrane at its first side to achieve an advantageous thermal transmission from the ambient along the outer side of the roof unit, but can also be protected against potential physical damages by the weather conditions due to the arrangement of the cover membrane.

The cover membrane is preferably a sheet-like element having a top and bottom surfaces defining a thickness there between. Preferably, the cover membrane has a length and width at least 5 times, preferably at least 25 times, more preferably at least 50 times greater than the thickness of the cover membrane.

Preferably, the cover membrane comprises a waterproofing layer comprising at least 45 wt.-%, preferably at least 55 wt.-%, more preferably at least 65 wt.-% of at least one polymer **P.** Suitable polymers to be used as the at least one polymer **P** include, for example, thermoplastic polymers, elastomers, and thermoplastic elastomers (TPE-O),

The detailed composition of the waterproofing layer is not particularly restricted, however, the waterproofing layer should be as waterproof as possible and not to decompose or be mechanically damaged even under prolonged influence of water or moisture.

According to one or more embodiments, the at least one polymer **P** has:
- a melting temperature determined by DSC according to ISO 11357 standard in the range of 55 - 250 °C, preferably 60 - 225 °C, more preferably 65 - 200 °C, even more preferably 70 - 185 °C, still more preferably 75 - 175 °C and/or
- a flexural modulus at 23 °C determined according to ISO 178 standard of not more than 2000 MPa, preferably not more than 1500 MPa, more preferably not more than 1250 MPa, even more preferably not more than 1000 MPa.

According to one or more embodiments, the at least one polymer **P** is selected from the group consisting of ethylene - vinyl acetate copolymer (EVA), ethylene - acrylic ester copolymers, ethylene - α-olefin co-polymers, ethylene - propylene co-polymers, propylene - α-olefin co-polymers, propylene - ethylene co-polymers, polyethylene (PE), polypropylene (PP), polyvinylchloride (PVC), polyethylene terephthalate (PET), polystyrene (PS), polyamides (PA), chlorosulfonated polyethylene (CSPE), ethylene propylene diene monomer rubber (EPDM), and polyisobutylene (PIB).

According to one or more further embodiments, the at least one polymer **P** is selected from the group consisting of propylene co-polymers, propylene - α-olefin co-polymers, propylene - ethylene co-polymers, polypropylene (PP), polyvinylchloride (PVC), chlorosulfonated polyethylene (CSPE), and ethylene propylene diene monomer rubber (EPDM).

The waterproofing layer can further comprise, in addition to the at least one polymer **P,** one or more additives such as UV- and heat stabilizers, antioxidants, plasticizers, fillers, flame retardants, dyes, pigments such as titanium dioxide and carbon black, matting agents, antistatic agents, impact modifiers, biocides, and processing aids such as lubricants, slip agents, antiblock agents, and denest aids.

According to one or more embodiment, the waterproofing layer comprises 1 - 60 wt.-%, preferably 5 - 60 wt.-%, more preferably 10 - 60 wt.-%, even more preferably 10 - 50 wt.-% of at least one flame retardant. Suitable flame retardants to be used in the waterproofing layer include, for example magnesium hydroxide, aluminum trihydroxide, and antimony trioxide, ammonium polyphosphate, and melamine-, melamine resin-, melamine derivative-, melamine-formaldehyde-, silane-, siloxane-, and polystyrene-coated ammonium polyphosphates.

Other suitable flame retardants include, for example, 1,3,5-triazine compounds, such as melamine, melam, melem, melon, ammeline, ammelide, 2-ureidomelamine, acetoguanamine, benzoguanamine, diaminophenyltriazine, melamine salts and adducts, melamine cyanurate, melamine borate, melamine orthophosphate, melamine pyrophosphate, dimelamine pyrophosphate and melamine polyphosphate, oligomeric and polymeric 1,3,5-triazine compounds and polyphosphates of 1,3,5-triazine compounds, guanine, piperazine phosphate, piperazine polyphosphate, ethylene diamine phosphate, pentaerythritol, borophosphate, 1,3,5-trihydroxyethylisocyanaurate, 1,3,5-triglycidylisocyanaurate, triallylisocyanurate and derivatives of the aforementioned compounds.

According to one or more embodiments, the cover membrane further comprises a reinforcement layer, which is may be at least partially embedded into the waterproofing layer. The reinforcement layer may be used to ensure the mechanical stability of the waterproofing layer when the cover membrane is exposed to varying environmental conditions, in particular to large temperature fluctuations. Any type of reinforcement layers commonly used for improving the dimensional stability of thermoplastic roofing membranes can be used. Preferable reinforcement layers include non-woven fabrics, woven fabrics, and non-woven scrims, and combinations thereof. According to one or more embodiments, the reinforcement layer comprises a non-woven fabric comprising inorganic and/or synthetic organic fibers and/or a non-woven scrim.

It may furthermore be preferable that the cover membrane has:
- a tensile modulus of elasticity determined according to EN ISO 527-3 of not more than 1500 MPa, preferably not more than 1250 MPa, more preferably not more than 1000 MPa, even more preferably not more than 850 MPa and/or
- an impact resistance measured according to EN 12691: 2005 standard of at least 200 mm, preferably at least 300 mm and/or
- a longitudinal and a transversal tensile strength measured at a temperature of 23°C according to DIN ISO 527-3 standard of at least 5 MPa, preferably at least 7.5 MPa and/or
- a longitudinal and transversal elongation at break measured at a temperature of 23°C according to DIN ISO 527-3 standard of at least 150 %, preferably at least 250% and/or
- a water resistance measured according to EN 1928 B standard of 0.6 bar for 24 hours and/or a maximum tear strength measured according to EN 12310-2 standard of at least 50 N, preferably at least 100 N.

Preferably, the cover membrane has a thickness of at least 0.05 mm, more preferably at least 0.1 mm. According to one or more embodiments, the cover membrane has a thickness of 0.05 - 10.0 mm, preferably 0.1 - 7.5 mm, more preferably 0.25 - 5.0 mm, even more preferably 0.35 - 3.5 mm, still more preferably 0.45 - 2.5 mm. The thickness of the cover membrane can be determined by using a measurement method as defined in DIN EN 1849-2 standard.

According to the present invention, the cover membrane is a roofing membrane.

In one preferred embodiment, the thermal bridge member extends along the complete surface area of the second side of the thermoelectric generator.

Thus, a maximum thermal transmission by the thermal bridge member is provided to achieve an advantageous temperature difference along the thermoelectric generator, in particular between the first side and the second side of the thermal bridge member.

In another embodiment, the at least one thermal bridge member is provided as a monobloc element. Preferably, the thermal bridge member is provided in one piece to extend from the inner side, in particular from an area along the inner side in order to absorb an inside temperature of the building, to the outer side of the insulation member. Thus, a thermal bridge effect to transfer the internal temperature of a building to the second side of the thermoelectric generator is achieved in an advantageous manner and without any interruptions for thermal transfer.

According to another embodiment, the roof unit comprises exactly one thermal bridge member which is in contact with the thermoelectric generator or multiple thermoelectric generators of the roof unit.

In particular, the roof unit can be provided with one single thermoelectric generator extending along the insulation member or multiple thermoelectric generators arranged along the insulation member, whereby the single thermal bridge member is capable of providing a suitable transfer of temperature from the inner side of the insulation member respectively. Irrespective of the amount of thermoelectric generators, one single thermal bridge member can be sufficient for the roof unit to achieve a suitable transfer of temperature.

In consequence, a simplified and optimized arrangement of the thermal bridge member, and thus of the roof unit, is provided.

In one embodiment, the thermal bridge member comprises a thermal conductivity of more than 1 W/mK, preferably more than 50 W/mK. Thus, a suitable transfer of temperature from the inner side of the insulation member to the outer side of the insulation member and to the second side of the thermoelectric generator is achievable.

According to another preferred embodiment, the thermoelectric generator is a thermoelectric generator which is optimized for low temperature applications, in particular for applications comprising temperatures lower than 180 °C.

In combination with the thermal bridge member, the internal temperature of a building can be transferred over a large distance, namely from the inner, lower side of the insulation member to the outer, upper side of the insulation member, to utilize the temperature difference between the internal temperature of a building and an outer temperature of the surrounding environment for power generation.

Further, in another embodiment, the thermal bridge member is made of an aluminium foil or a metal grid. In particular, the thermal bridge member can be made of aluminium foil with a thickness of e.g. 0.3 mm. According to one or more embodiments, the thermal bridge is composed of aluminium foil having a thickness of not more than 1.5 mm, preferably not more than 1.0 mm, more preferably not more than 0.75 mm, even more preferably not more than 0.5 mm.

Thus, the thermal bridge member comprises an advantageous thermal conductivity and is easily available as well as processable in order to provide a roof unit for power generation according to the present invention. In particular, an advantageous use of temperature gradients can be made usable by combining a low temperature thermoelectric generator with the thermal bridge member.

In a further embodiment of the invention, the at least one thermoelectric generator comprises a maximum thickness of 10 mm. Thus, a thin and space-saving arrangement of the roof unit and its components can be achieved.

According to another embodiment, the first side of the thermoelectric generator is fitted to the cover membrane by an adhesive, in particular by an adhesive comprising a thermal conductivity of more than 1 W/mK.

Thus, a direct contact in terms of a side by side arrangement of the cover membrane and the at least one thermoelectric generator is achieved for optimum temperature transfer to the first side of the thermoelectric generator. Consequently, a suitable temperature difference between the first and second side of the thermoelectric generator can be provided for energy / power generation.

In another preferred embodiment, one thermoelectric generator or multiple thermoelectric generators is/are arranged along the outer side of the insulation member such that the outer side of the insulation member is substantially covered, in particular completely covered, by the at least one thermoelectric generator.

Thus, the whole area of the roof unit is preferably optimized for generation of electrical energy by the thermoelectric generator(s). A maximum surface area of the outer side of the insulation member can be utilized advantageously.

Another aspect of the invention refers to a rooftop system comprising at least two roof units according to the invention, whereby the roof units, in particular its respective thermoelectric generators, can be electrically connected in series and/or in parallel. According to one preferred embodiment, the rooftop system comprises a controller unit in electrical connection with the roof units, in particular the respective thermoelectric generators, to provide a suitable electrical output, in particular a suitable output voltage.

Thus, multiple roof units can be arranged in a suitable manner to provide an advantageous energy generation along a whole rooftop of e.g. a building. In order to provide an appropriately controlled output of the multiple thermoelectric generators of the several roof units, a suitable control unit is provided.

In particular, the control unit can be provided as a voltage controller. Thus, an appropriate output of the thermoelectric generators of the roof units is achievable.

According to another aspect of the invention, a method for manufacturing a roof unit and/or a rooftop system according to the invention is provided, whereby the exterior surface of the insulation member is at least partially covered with the thermal bridge member to provide a thermal bridge between the inner side and the outer side of the insulation member.

Preferably, the exterior surface of the insulation member can be substantially covered by the thermal bridge member. More preferably, the exterior surface of the insulation member can be completely covered by the thermal bridge member. Thus, a suitable transfer of the inside temperature of a building around the insulation member from its inner, lower side to its outer, upper side and to the thermoelectric generator, in particular its second side, is providable.

According to the present invention, the method for manufacturing a roof unit and/or a rooftop system according to the invention comprises steps of providing an insulation member, applying a thermal bridge member to cover at least a portion of the exterior surface of the insulation member, arranging at least one thermoelectric generator on the thermal bridge member such that the second side of the thermoelectric generator and the outer side of the insulation member are arranged next to each other and are separated from each other by the thermal bridge member, and covering the first side of the at least one thermoelectric generator with a cover membrane, wherein the cover membrane is a roofing membrane.

In the following, the present invention will be described in more detail with reference to the enclosed Figure.

It is schematically shown:

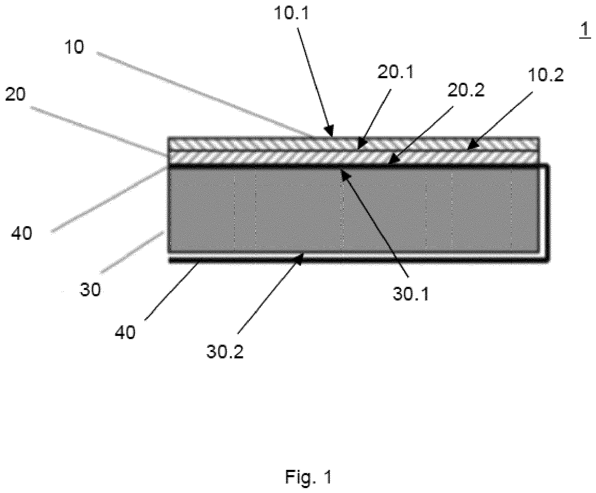

- Fig. 1: cross-sectional view of an exemplary embodiment of the roof unit according to the present invention.

According to Fig. 1 the roof unit 1 comprises a cover membrane 10, a thermoelectric generator 20 and an insulation member 30 which are arranged next to each other, in particular above each other.

The cover membrane 10 is directly attached to the thermoelectric generator 20, preferably by an adhesive comprising a thermal conductivity of more than 1 W/mK. Consequently, an advantageous transfer of temperature can be provided from an outer side 10.1 of the cover membrane 10 to a first side 20.1 of the thermoelectric generator 20.

Thereby, the outer side 10.1 of the cover membrane 10 preferably represents an outer side of the roof unit 1 or the corresponding rooftop as well. Additionally, the first side 20.1 of the thermoelectric generator 20 is preferably glued to and thus in contact with an inner side 10.2 of the cover membrane 10.

Further, the insulation member 30 is arranged next to the thermoelectric generator 20, whereby the insulation member 30 and the thermoelectric generator 20 are separated by a thermal bridge member 40. In particular, an outer side surface 30.1 of the insulation member 30 and a second side 20.2 of the thermoelectric generator 20 are directed towards each other with at least one layer of the thermal bridge member 40 being situated inbetween.

According to Fig. 1, the thermal bridge member 40 extends along the complete surface of the outer side 30.1 of the insulation member 30 and of the second side 20.2 of the thermoelectric generator 20. Further, the thermal bridge member 40 extends along a side surface of the insulation member 30 in its direction of thickness and further along the inner side 30.2 of the insulation member 30.

Thus, the thermal bridge member 40 is situated in an area along the whole inner surface 30.2 of the insulation member 30 as well.

Thereby, the thermal bridge member 40 is not necessarily in contact with the inner side 30.2 of the insulation member but is capable of receiving an inside temperature of a building which occurs along this inner side 30.2 of the insulation member 30. With the thermal bridge member 40, it is possible to provide a thermal bridge, in particular a thermal bypass, between the inner side 30.2 of the insulation member 30 and the second side 20.2 of the thermoelectric generator 20.

Consequently, a temperature gradient can be provided between the first side 20.1, in appropriate contact with the cover membrane 10, and the second side 20.2, in appropriate contact with the thermal bridge member 40, of the thermoelectric generator 20 in order to generate electrical power.

Moreover, the thermal bridge member 40, extending from the outer side 30.1 to the inner side 30.2 and along the direction of thickness of the insulation member 30, is provided as a one-piece, or monobloc, thermal bridge member 40 according to Fig. 1.

In summary, the present invention is based on the approach to generate electrical energy by utilizing at least one thermoelectric generator 20 in combination with a thermal bridge member 30 within a roof unit 1 for a rooftop, in particular for a rooftop of a building.

By advantageous thermal coupling of the respective sides 20.1; 20.2 of the thermoelectric generator 20 with the cover membrane 10 and the thermal bridge member 40, a suitable temperature difference / gradient can be applied to the thermoelectric generator 20. Thereby, the thermal bridge member 40 allows to transfer an inside / internal temperature of the building around the insulation member 30 to the thermoelectric generator 20, thus bypassing the insulation member 30.

In addition thereto, especially the combination of the cover membrane 10, the at least one thermoelectric generator 20 and the thermal bridge member 40 allows a thin and space-saving arrangement of the roof unit, which is manufacturable in a simplified and cost-effective manner.

### List of references

- 1: Roof unit
- 10: Cover membrane
- 10.1: Outer side of cover membrane
- 10.2: Inner side of cover membrane
- 20: Thermoelectrical generator
- 20.1: First side of thermoelectrical generator
- 20.2: Second side of thermoelectrical generator
- 30: Insulation member
- 30.1: Outer side of insulation member
- 30.2: Inner side of insulation member
- 40: Thermal bridge member

## Claims

1. Roof unit (1), in particular for buildings, comprising a cover membrane (10), at least one thermoelectric generator (20) for providing electrical energy with a first side (20.1) and a second side (20.2), an insulation member (30) with an outer (30.1) and an inner side (30.2), and at least one thermal bridge member (40),
whereby the cover membrane (10) is attached to the first side (20.1) of the thermoelectric generator (20),
whereby the second side (20.2) of the thermoelectric generator (20) and the outer side (30.1) of the insulation member (30) are arranged next to each other and are separated from each other by the thermal bridge member (40),
whereby the thermal bridge member (40) partially extends between the second side (20.2) of the thermoelectric generator (20) and the outer side (30.1) of the insulation member (30), and
whereby the thermal bridge member (40) reaches to the inner side (30.2) of the insulation member (30) along a thickness of the insulation member (30) such that a thermal bridge between an area along the inner side (30.2) of the insulation member and the second side (20.2) of the thermoelectric generator (20) is provided, **characterized in that** the cover membrane (10) is a roofing membrane.

2. Roof unit (1) according to claim 1,
**characterized in that**
the thermal bridge member (40) extends around at least a part of an exterior surface, in particular along the inner and outer surface (30.1; 30.2), of the insulation member (30), preferably around the complete exterior surface of the insulation member (30).

3. Roof unit (1) according to claim 1 or 2,
**characterized in that**
the first side (20.1) of the at least one thermoelectric generator (20) is completely covered by the cover membrane (10).

4. Roof unit (1) according to any of the preceding claims,
**characterized in that** the cover membrane (10) comprises a waterproofing layer comprising at least 45 wt.-%, preferably at least 55 wt.-%, more preferably at least 65 wt.-% of at least one polymer **P.**

5. Roof unit according to any of the preceding claims,
**characterized in that** the cover membrane (10) has a thickness of 0.25 - 5.0 mm, preferably 0.35 - 3.5 mm, more preferably 0.45 - 2.5 mm.

6. Roof unit (1) according to any of the preceding claims,
**characterized in that**
the thermal bridge member (40) extends along the complete surface area of the second side (20.2) of the thermoelectric generator (20).

7. Roof unit (1) according to any of the preceding claims,
**characterized in that**
the at least one thermal bridge member (40) is provided as a monobloc element.

8. Roof unit (1) according to any of the preceding claims,
**characterized in that**
the roof unit (1) comprises exactly one thermal bridge member (40) which is in contact with the thermoelectric generator (20) or multiple thermoelectric generators (20) of the roof unit (1).

9. Roof unit (1) according to any of the preceding claims,
**characterized in that**
the thermal bridge member (40) comprises a thermal conductivity of more than 1 W/mK, preferably more than 50 W/mK.

10. Roof unit (1) according to any of the preceding claims,
**characterized in that**
the thermoelectric generator (20) is a thermoelectric generator (20) which is optimized for applications comprising temperatures lower than 180 °C.

11. Roof unit (1) according to any of the preceding claims,
**characterized in that**
the thermal bridge member (40) is made of an aluminium foil or a metal grid.

12. Roof unit (1) according to any of the preceding claims,
**characterized in that**
the at least one thermoelectric generator (20) comprises a maximum thickness of 10 mm.

13. Roof unit (1) according to any of the preceding claims,
**characterized in that**
the first side of the thermoelectric generator (20) is fitted to the cover membrane (10) by an adhesive, in particular by an adhesive comprising a thermal conductivity of more than 1 W/mK.

14. Roof unit (1) according to any of the preceding claims,
**characterized in that**
one thermoelectric generator (20) or multiple thermoelectric generators (20) is/are arranged along the outer side (30.1) of the insulation member (30) such that the outer side (30.1) of the insulation member (30) is substantially covered, in particular completely covered, by the at least one thermoelectric generator (20).

15. Rooftop system comprising at least two roof units (1) according to one of the preceding claims, whereby the roof units (1), in particular its respective thermoelectric generators (20), are electrically connected in series and/or in parallel.

16. Rooftop system according to claim 15,
**characterized in that**
the rooftop system comprises a controller unit in electrical connection with the roof units, in particular the respective thermoelectric generators (20), to provide a suitable electrical output, in particular a suitable output voltage.

17. Method for manufacturing a roof unit (1) and/or a rooftop system according to one of the preceding claims,
whereby the exterior surface of the insulation member (30) is at least partially covered by the thermal bridge member (40) to provide a thermal bridge between the inner side (30.2) and the outer side (30.1) of the insulation member (30), wherein the method comprises steps of providing an insulation member (30), applying a thermal bridge member (40) to cover at least a portion of the exterior surface of the insulation member, arranging at least one thermoelectric generator (20) on the thermal bridge member (40) such that the second side (20.2) of the thermoelectric generator (20) and the outer side (30.1) of the insulation member (30) are arranged next to each other and are separated from each other by the thermal bridge member (40), and covering the first side (20.1) of the at least one thermoelectric generator (20) with a cover membrane (10), **characterized in that** the cover membrane (10) is a roofing membrane.

## Patentansprüche

1. Dachmodul (1), insbesondere für Gebäude, eine Abdeckmembran (10), mindestens einen thermoelektrischen Generator (20) zum Bereitstellen von elektrischer Energie mit einer ersten Seite (20.1) und mit einer zweiten Seite (20.2), ein Isolierelement (30) mit einer äußeren (30.1) und einer inneren Seite (30.2) und mindestens ein Wärmebrückenelement (40) umfassend,
wobei die Abdeckmembran (10) an der ersten Seite (20.1) des thermoelektrischen Generators (20) befestigt ist,
wobei die zweite Seite (20.2) des thermoelektrischen Generators (20) und die äußere Seite (30.1) des Isolierelements (30) nebeneinander angeordnet sind und durch das Wärmebrückenelement (40) voneinander getrennt sind,
wobei sich das Wärmebrückenelement (40) teilweise zwischen der zweiten Seite (20.2) des thermoelektrischen Generators (20) und der äußeren Seite (30.1) des Isolierelements (30) erstreckt und
wobei das Wärmebrückenelement (40) die innere Seite (30.2) des Isolierelements (30) entlang einer Dicke des Isolierelements (30) derartig erreicht, dass eine Wärmebrücke zwischen einem Bereich entlang der inneren Seite (30.2) des Isolierelements und der zweiten Seite (20.2) des thermoelektrischen Generators (20) bereitgestellt wird, **dadurch gekennzeichnet, dass** die Abdeckmembran (10) eine Dachmembran ist.

2. Dachmodul (1) nach Anspruch 1,
**dadurch gekennzeichnet, dass** sich das Wärmebrückenelement (40) um mindestens einen Teil einer Außenfläche, insbesondere entlang der inneren und der äußeren Oberfläche (30.1; 30.2), des Isolierelements (30) herum, vorzugsweise um die gesamte Außenfläche des Isolierelements (30) herum, erstreckt.

3. Dachmodul (1) nach Anspruch 1 oder 2,
**dadurch gekennzeichnet, dass** sie erste Seite (20.1) des mindestens einen thermoelektrischen Generators (20) durch die Abdeckmembran (10) vollständig abgedeckt wird.

4. Dachmodul (1) nach einem der vorhergehenden Ansprüche,
**dadurch gekennzeichnet, dass** die Abdeckmembran (10) eine Sperrschicht umfasst, die mindestens 45 Masse-%, vorzugsweise mindestens 55 Masse-%, besonders bevorzugt mindestens 65 Masse-% von mindestens einem Polymer P umfasst.

5. Dachmodul nach einem der vorhergehenden Ansprüche,
**dadurch gekennzeichnet, dass** die Abdeckmembran (10) eine Dicke von 0,25 bis 5,0 mm, vorzugsweise von 0,35 bis 3,5 mm, besonders bevorzugt von 0,45 bis 2,5 mm aufweist.

6. Dachmodul (1) nach einem der vorhergehenden Ansprüche,
**dadurch gekennzeichnet, dass** sich das Wärmebrückenelement (40) entlang des gesamten Oberflächenbereichs der zweiten Seite (20.2) des thermoelektrischen Generators (20) erstreckt.

7. Dachmodul (1) nach einem der vorhergehenden Ansprüche,
**dadurch gekennzeichnet, dass** das mindestens eine Wärmebrückenelement (40) als ein Monoblockelement bereitgestellt ist.

8. Dachmodul (1) nach einem der vorhergehenden Ansprüche,
**dadurch gekennzeichnet, dass** das Dachmodul (1) genau ein Wärmebrückenelement (40) umfasst, das mit dem thermoelektrischen Generator (20) oder mit mehreren thermoelektrischen Generatoren (20) des Dachmoduls (1) in Kontakt steht.

9. Dachmodul (1) nach einem der vorhergehenden Ansprüche,
**dadurch gekennzeichnet, dass** das Wärmebrückenelement (40) eine Wärmeleitfähigkeit von mehr als 1 W/mK, vorzugsweise von mehr als 50 W/mK umfasst.

10. Dachmodul (1) nach einem der vorhergehenden Ansprüche,
**dadurch gekennzeichnet, dass** der thermoelektrische Generator (20) ein thermoelektrischer Generator (20) ist, der für Anwendungen optimiert ist, die geringere Temperaturen als 180 °C umfassen.

11. Dachmodul (1) nach einem der vorhergehenden Ansprüche,
**dadurch gekennzeichnet, dass** das Wärmebrückenelement (40) aus einer Aluminiumfolie oder einem Metallgitter angefertigt ist.

12. Dachmodul (1) nach einem der vorhergehenden Ansprüche,
**dadurch gekennzeichnet, dass** der mindestens eine thermoelektrische Generator (20) eine maximale Dicke von 10 mm umfasst.

13. Dachmodul (1) nach einem der vorhergehenden Ansprüche,
**dadurch gekennzeichnet, dass** die erste Seite des thermoelektrischen Generators (20) durch einen Klebstoff an der Abdeckmembran (10) anliegt, insbesondere durch einen Klebstoff, der eine Wärmeleitfähigkeit von mehr als 1 W/mK umfasst.

14. Dachmodul (1) nach einem der vorhergehenden Ansprüche,
**dadurch gekennzeichnet, dass** ein thermoelektrischer Generator (20) oder mehrere thermoelektrische Generatoren (20) entlang der äußeren Seite (30.1) des Isolierelements (30) derartig angeordnet ist/sind, dass die äußere Seite (30.1) des Isolierelements (30) durch den mindestens einen thermoelektrischen Generator (20) im Wesentlichen abgedeckt, insbesondere vollständig abgedeckt, wird.

15. Dachsystem mindestens zwei Dachmodule (1) nach einem der vorhergehenden Ansprüche umfassend, wobei die Dachmodule (1), insbesondere ihre jeweiligen thermoelektrischen Generatoren (20), elektrisch in Reihe und/oder parallel geschaltet sind.

16. Dachsystem nach Anspruch 15,
**dadurch gekennzeichnet, dass** das Dachsystem eine Steuereinheit in elektrischer Verbindung mit den Dachmodulen, insbesondere mit den jeweiligen thermoelektrischen Generatoren (20), umfasst, um eine geeignete elektrische Ausgabe, insbesondere eine geeignete Ausgangsspannung, bereitzustellen.

17. Verfahren zum Herstellen eines Dachmoduls (1) und/oder eines Dachsystems nach einem der vorhergehenden Ansprüche,
wobei die Außenfläche des Isolierelements (30) mindestens teilweise durch das Wärmebrückenelement (40) abgedeckt wird, um eine Wärmebrücke zwischen der inneren Seite (30.2) und der äußeren Seite (30.1) des Isolierelements (30) bereitzustellen, wobei das Verfahren Schritte des Bereitstellens eines Isolierelements (30), des Aufbringens eines Wärmebrückenelements (40), um mindestens einen Abschnitt der Außenfläche des Isolierelements abzudecken, des Anordnens von mindestens einem thermoelektrischen Generator (20) auf dem Wärmebrückenelement (40), so dass die zweite Seite (20.2) des thermoelektrischen Generators (20) und die äußere Seite (30.1) des Isolierelements (30) nebeneinander angeordnet sind und durch das Wärmebrückenelement (40) voneinander getrennt sind, und des Abdeckens der ersten Seite (20.1) des mindestens einen thermoelektrischen Generators (20) mit einer Abdeckmembran (10) umfasst, **dadurch gekennzeichnet, dass** die Abdeckmembran (10) eine Dachmembran ist.

## Revendications

1. Unité de toit (1), en particulier pour bâtiments, comprenant une membrane de couverture (10), au moins un générateur thermoélectrique (20) pour fournir de l'énergie électrique avec un premier côté (20.1) et un deuxième côté (20.2), un élément d'isolation (30) avec un côté externe (30.1) et un côté interne (30.2), et au moins un élément de pont thermique (40),
dans laquelle la membrane de couverture (10) est attachée au premier côté (20.1) du générateur thermoélectrique (20),
dans laquelle le deuxième côté (20.2) du générateur thermoélectrique (20) et le côté externe (30.1) de l'élément d'isolation (30) sont disposés l'un à côté de l'autre et sont séparés l'un de l'autre par l'élément de pont thermique (40),
dans laquelle l'élément de pont thermique (40) s'étend partiellement entre le deuxième côté (20.2) du générateur thermoélectrique (20) et le côté externe (30.1) de l'élément d'isolation (30), et
dans laquelle l'élément de pont thermique (40) atteint le côté interne (30.2) de l'élément d'isolation (30) le long d'une épaisseur de l'élément d'isolation (30) de telle sorte qu'un pont thermique entre une zone le long du côté interne (30.2) de l'élément d'isolation et le deuxième côté (20.2) du générateur thermoélectrique (20) est obtenu, **caractérisée en ce que** la membrane de couverture (10) est une membrane de toiture.

2. Unité de toit (1) selon la revendication 1,
**caractérisée en ce que**
l'élément de pont thermique (40) s'étend autour d'au moins une partie d'une surface extérieure, en particulier le long des surfaces interne et externe (30.1 ; 30.2) de l'élément d'isolation (30), de préférence autour de la surface extérieure complète de l'élément d'isolation (30) .

3. Unité de toit (1) selon la revendication 1 ou 2,
**caractérisée en ce que**
le premier côté (20.1) de l'au moins un générateur thermoélectrique (20) est complètement recouvert par la membrane de couverture (10).

4. Unité de toit (1) selon l'une quelconque des revendications précédentes,
**caractérisée en ce que** la membrane de couverture (10) comprend une couche d'étanchéité comprenant au moins 45 % en poids, de préférence au moins 55 % en poids, mieux encore au moins 65 % en poids d'au moins un polymère P.

5. Unité de toit selon l'une quelconque des revendications précédentes,
**caractérisée en ce que** la membrane de couverture (10) a une épaisseur de 0,25-5,0 mm, de préférence 0,35-3,5 mm, mieux encore 0,45-2,5 mm.

6. Unité de toit (1) selon l'une quelconque des revendications précédentes,
**caractérisée en ce que**
l'élément de pont thermique (40) s'étend le long de la superficie complète du deuxième côté (20.2) du générateur thermoélectrique (20).

7. Unité de toit (1) selon l'une quelconque des revendications précédentes,
**caractérisée en ce que**
l'au moins un élément de pont thermique (40) est fourni sous la forme d'un élément monobloc.

8. Unité de toit (1) selon l'une quelconque des revendications précédentes,
**caractérisée en ce que**
l'unité de toit (1) comprend exactement un élément de pont thermique (40) qui est en contact avec le générateur thermoélectrique (20) ou de multiples générateurs thermoélectriques (20) de l'unité de toit (1) .

9. Unité de toit (1) selon l'une quelconque des revendications précédentes,
**caractérisée en ce que**
l'élément de pont thermique (40) présente une conductivité thermique de plus de 1 W/mK, de préférence plus de 50 W/mK.

10. Unité de toit (1) selon l'une quelconque des revendications précédentes,
**caractérisée en ce que**
le générateur thermoélectrique (20) est un générateur thermoélectrique (20) qui est optimisé pour des applications présentant des températures inférieures à 180 °C.

11. Unité de toit (1) selon l'une quelconque des revendications précédentes,
**caractérisée en ce que**
l'élément de pont thermique (40) est constitué d'une feuille d'aluminium ou d'un treillis métallique.

12. Unité de toit (1) selon l'une quelconque des revendications précédentes,
**caractérisée en ce que**
l'au moins un générateur thermoélectrique (20) présente une épaisseur maximale de 10 mm.

13. Unité de toit (1) selon l'une quelconque des revendications précédentes,
**caractérisée en ce que**
le premier côté du générateur thermoélectrique (20) est fixé sur la membrane de couverture (10) par un adhésif, en particulier par un adhésif présentant une conductivité thermique de plus de 1 W/mK.

14. Unité de toit (1) selon l'une quelconque des revendications précédentes,
**caractérisée en ce que**
un générateur thermoélectrique (20) ou de multiples générateurs thermoélectriques (20) est/sont disposé(s) le long du côté externe (30.1) de l'élément d'isolation (30) de telle sorte que le côté externe (30.1) de l'élément d'isolation (30) est en grande partie recouvert, en particulier complètement recouvert, par l'au moins un générateur thermoélectrique (20).

15. Système de toiture-terrasse comprenant au moins deux unités de toit (1) selon une des revendications précédentes, dans lequel les unités de toit (1), en particulier leurs générateurs thermoélectriques respectifs (20), sont branchés électriquement en série et/ou en parallèle.

16. Système de toiture-terrasse selon la revendication 15,
**caractérisé en ce que**
le système de toiture-terrasse comprend une unité de contrôle branchée électriquement aux unités de toit, en particulier aux générateurs thermoélectriques respectifs (20), pour fournir une sortie électrique appropriée, en particulier une tension de sortie appropriée.

17. Procédé de fabrication d'une unité de toit (1) et/ou d'un système de toiture-terrasse selon une des revendications précédentes,
dans lequel la surface extérieure de l'élément d'isolation (30) est au moins partiellement recouverte par l'élément de pont thermique (40) pour obtenir un pont thermique entre le côté interne (30.2) et le côté externe (30.1) de l'élément d'isolation (30),
le procédé comprenant les étapes d'obtention d'un élément d'isolation (30), application d'un élément de pont thermique (40) pour recouvrir au moins une partie de la surface extérieure de l'élément d'isolation, mise en place d'au moins un générateur thermoélectrique (20) sur l'élément de pont thermique (40) de telle sorte que le deuxième côté (20.2) du générateur thermoélectrique (20) et le côté externe (30.1) de l'élément d'isolation (30) soient disposés l'un à côté de l'autre et soient séparés l'un de l'autre par l'élément de pont thermique (40), et recouvrement du premier côté (20.1) de l'au moins un générateur thermoélectrique (20) avec une membrane de couverture (10), **caractérisé en ce que** la membrane de couverture (10) est une membrane de toiture.
